# EUROPEAN PATENT SPECIFICATION

(11) **EP 1 471 495 B1**
(45) Date of publication and mention of the grant of the patent: **18.01.2012**
(21) Application number: 03024960.1
(22) Date of filing: 29.10.2003
(51) Int. Cl.: G09G 3/34

(54) **Dynamic self-refresh display memory**
Dynamischer selbstauffrischender Anzeigespeicher
Mémoire dynamique à autogénération pour un affichage

(30) Priority: 24.04.2003 US 423517
(43) Date of publication of application: 27.10.2004
(60) Divisional application: 08019119.0
(73) Proprietor: Taiwan Semiconductor Manufacturing Company, Ltd., Taiwan 300-77 (TW)
(72) Inventor: Schloeman, Dennis J., Corvallis, OR 97330 (US); Mar, Eugene J., Corvallis, OR 97330 (US)
(74) Representative: Schoppe, Fritz

(56) References cited:
- US-A- 5 285 407
- US-A- 5 612 713
- US-A- 5 670 977
- US-A- 5 677 703
- US-A1- 2002 012 159
- US-A1- 2002 180 675
- US-A1- 2003 016 202

## Description

### TECHNICAL FIELD

This invention relates to display memories and more particularly to a dynamic memory for storing data in a display having at least one MEMS device for each pixel.

### BACKGROUND

Displays and light-projectors using arrays of MEMS devices such as the micromirrors of Digital Micromirror Devices™ (DMD's) have been developed for a number of applications. ("Digital Micromirror Device™^{"} is a trademark of Texas Instruments.) For some applications, DMD's include a static random-access memory (SRAM) for storing image data and addressing the array of micromirrors. Thus, the DMD SRAM's have used memory cells having a single static memory cell per pixel. Typically, each mirror in an array of mirrors is suspended above an individual SRAM cell in a corresponding array of memory cells. Address electrodes are connected to the SRAM nodes at which "1" or "0" voltages are set.

Electrostatic forces applied between the address electrodes and the mirrors rotate the mirrors about an axis. The rotation is stopped at predetermined angles, limited by touching of an edge of the mirror at the substrate. Gray scale in images is accomplished by using pulse width modulation of the binary ON (1) and OFF (0) times of each mirror. Such digital operation of DMD's and other MEMS-based display arrays imposes bandwidth requirements on the display's circuitry for filling the array with data for each frame to be displayed.

Some DMD displays take advantage of mechanical latching of the mirrors and some DMD displays utilize architectures having SRAM's smaller than the micromirror array, in the sense of having a number of SRAM cells that is a fraction of the number of micromirrors in the micromirror array. In such architectures, the peak data rate can be made comparable to the average data rate. As faster and larger arrays of MEMS devices are developed for displays and other applications, further reduction of bandwidth is a very desirable goal, especially if it can be achieved in a way that does not depend on particular physical characteristics of the MEMS devices in the array.

US 2002/012159 A describes a frame-addressed bistable micromirror array. An analog input signal representing the desired intensity of an image pixel is applied to input. An address signal synchronized to the analog input signal is applied to input of a given micromirror cell to store the pixel intensity information on input capacitor. After intensity information for each pixel in the video frame or field, or a portion of the frame of field, is stored on the input capacitor of the appropriate micromirror cell, a frame signal is applied to input to enable the transfer of charge.

US 2003/016202 A1 describes an active matrix device that includes a plurality of display elements including a data storage node for storing data in the form of charge on a capacitor and/or capacitive element. A refresh circuitry is provided to refresh the data storage node.

### SUMMARY OF THE INVENTION

It is an object of the invention to provide an improved memory cell for a display having at least one MEMS device for each pixel and a method for manufacturing same.

This object is achieved by a memory cell of claim 1, and by a method of claim 13.

### BRIEF DESCRIPTION OF THE DRAWINGS

The features and advantages of the invention will be readily appreciated by persons skilled in the art from the following detailed description when read in conjunction with the drawings, wherein:
FIG. 1 is a schematic diagram of an embodiment of a memory cell made in accordance with the invention.
FIG. 2 is a timing diagram of the memory cell embodiment shown in FIG. 1.

### DETAILED DESCRIPTION OF EMBODIMENTS

For clarity, the following detailed description focuses on a particular simple embodiment of a dynamic self-refreshing memory cell for a MEMS device of an array of MEMS devices. Those skilled in the art will recognize that the invention may be readily implemented in other similar embodiments. For specificity, the MEMS device with which the invention is used may be considered to be a digital micromirror device (DMD), but the invention may be applied to any kind of MEMS device and to an array of any kind of MEMS devices.

Throughout this specification and the appended claims, the term "MEMS" has its conventional meaning of a micro-electro-mechanical system. Where particular devices are designated as "P-channel" or "N-channel," etc. for specificity of the description of a particular example embodiment, those skilled in the art will recognize that bipolar devices or other combinations of device types may be used with appropriate signals.

Embodiments made in accordance with the present invention have a dynamic memory cell for storing data in a display having at least one MEMS device for each pixel. The dynamic memory cell has at least two dynamic memory elements per pixel, including first and second dynamic memory elements, each including at least one capacitor for storing charge. Both of the first and second memory elements are electrically coupled to the MEMS device of a single pixel. A sense amplifier is configured to amplify the data signal and to latch data in response to a differential data signal and a clock signal, self-refreshing the data and loading data to the MEMS device as required. The same sense amplifier may be used to read the data stored (e.g., for testing), as is discussed in more detail hereinbelow.

Other embodiments made in accordance with the present invention have a number N of dynamic memory elements per pixel, where N is greater than two. Embodiments with exactly two dynamic memory elements per pixel reduce the data bandwidth by a factor of two. Those skilled in the art will recognize that, similarly, embodiments with N dynamic memory elements per pixel can reduce the data bandwidth by about a factor of 2^{(N-1)} . It is convenient for many such applications to make N an even number. Of course, larger values of the number N require larger numbers of transistors or other active devices, and there are costs associated with the additional active devices, including fabrication costs, yield-related costs, and reliability-related costs. Thus, in practical applications there are tradeoffs among bandwidth reduction, device fabrication costs, and various other cost factors which are familiar to those skilled in the art.

The memory for a display device has a number of memory cells, at least one memory cell for each pixel of the display. The memory cell or an entire array of memory cells may be incorporated into an integrated circuit, may be incorporated on a substrate carrying microelectronics, and may be incorporated into an electronic device.

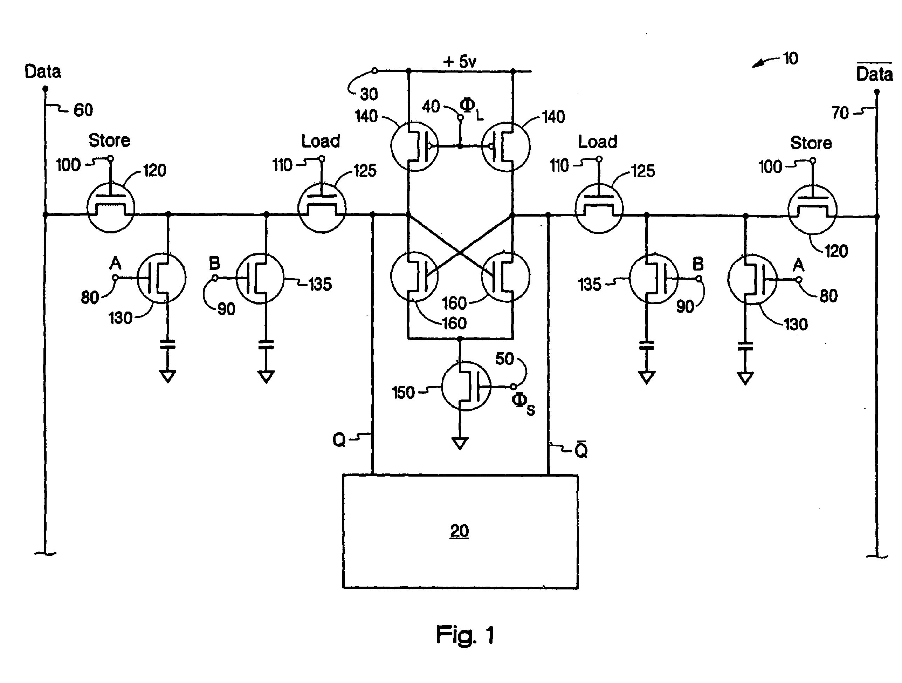

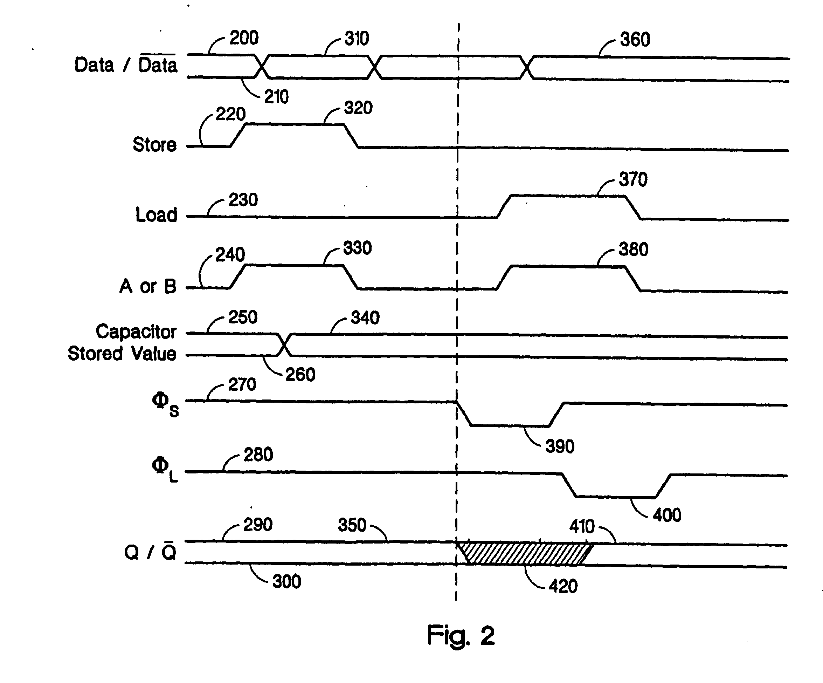

FIG. 1 shows a schematic diagram of a simple embodiment of a memory cell **10** made in accordance with the invention. A representative timing diagram of the memory cell embodiment of FIG. 1 is shown in FIG. 2. The schematic diagram shows a two-memory-element dynamic memory cell with thirteen transistors and four capacitors driving a MEMS device **20** for a single pixel of a display or of an array of other MEMS devices.

Memory cell **10** may be used in a display of the type having at least one MEMS device **20** corresponding to each pixel. It will be understood that MEMS device **20** may be more complex than a simple micromirror and may, in fact, comprise more than one MEMS device, but for purposes of understanding the embodiment illustrated in FIGS. 1 and 2, MEMS device **20** may be considered to be a simple MEMS micromirror.

Memory cell **10** is used for storing data in response to a data signal provided as a differential signal including true and complementary data lines (true signal **60** and its complementary signal **70**) and a clock signal **50** (**Φₛ**). This particular embodiment has exactly two dynamic memory elements per pixel. Each of the two dynamic memory elements has a capacitor for charge storage. (In FIG. 1, the capacitors are designated as A or B capacitors, corresponding to the designation at the gates **80** or **90** of their associated transistors **130**.) Both of the two dynamic memory elements are electrically coupled to the MEMS device **20** of a single pixel, as shown in FIG. 1. A sense amplifier (defined by devices **140**, **150**, and **160** as described hereinbelow) is configured to amplify the data signal and to latch data in response to the data signals **60** and **70** as timed by clock signal **50**. For illustrative purposes, VDD power supply line **30** is shown in FIG. 1 as supplying +5V; that supply voltage is chosen to be suitable for the application and for the active device types used.

One of the problems with implementing a dynamic memory approach is refreshing the charge- storage capacitors in the memory cells. The same sense amplifier for each pixel is used to refresh the local charge-storage elements. Thus, the dynamic memory cell **10** of FIG. 1 is a self-refreshing memory cell.

Reading of the stored data does not have to be fast, since reading is required for test purposes only. For read operations, the sense amplifier is also used to drive the read data on the bit lines.

In the sense amplifier, P-channel device **140** is enabled when Φ**_{L}** is asserted low. Device **140** allows signals **Q** and **/Q** (shown in the drawings with an overbar) to be attached to VDD through high impedance loads in order to amplify the **Q** and **/Q** signal value. Amplification can occur only after one of two storage capacitors is enabled by either device **130** or **135** and devices **125** and **150** are also enabled. N-channel device **150** is enabled when Φ**ₛ** is asserted high. Device **150** allows a signal path to ground for cross-coupled devices **160** so that **Q** and **/Q** can be amplified when device **140** is enabled. N-channel devices **160** form the cross-coupled devices of the sense amplifier. Devices **160** are used for positive feedback of signals on **Q** and **/Q** so that those signals can be amplified when device **150** is enabled first and then device **140** is enabled second.

The dynamic memory cell with two memory elements per pixel requires at least two capacitors and requires fewer transistors than an SRAM memory cell would require. (A static SRAM approach with two memory elements per pixel would require about twenty transistors.) The dynamic memory cell has one sense amplifier per pixel to latch the appropriate input data and to amplify the data signal to an amplitude voltage suitable for actuating the MEMS device. If the MEMS device is a micromirror, for example, the voltage level from the sense amplifier is suitable for actuating a micro-mirror device. For simplicity, it is assumed in this description that the MEMS device holds a binary value loaded into it for at least a suitable predetermined time after the value is loaded.

The following description will be more readily understood by reference to the timing diagram in FIG. 2 in conjunction with the schematic diagram of FIG. 1. In FIG. 1, the charge-storage capacitors are identified as **A** or **B** capacitors by the reference letter **A** or **B** shown at the gate of each corresponding FET device **130** or **135** respectively. The bit line of the memory consists of a conventional complementary signal pair, DATA and its complement /DATA (shown in the drawings with an overbar), represented by vertical lines **60** and **70** in FIG. 1. As indicated at the lower ends of the DATA and /DATA lines in FIG. 1, these may extend to other memory cells of an array. Other elements in FIG. 1 are described in more detail below.

In the timing diagram, FIG. 2, the vertical dashed line divides the time to distinguish the STORE portion (left) from the LOAD portion (right). FIG. 2 shows the DATA and /DATA signals (**200** and **210** respectively) and their values **310** and **360** at different times, the STORE signal **220** and its value **320** when asserted, the LOAD signal **230** and its value **370** when asserted, the **A** or **B** selection signal **240** and its values **330** for a STORE operation and **380** for a LOAD operation, the capacitor stored values **250** and **260** with representative value **340,** STORE clock signal **Φ_{S}(270)** and its value **390** at a certain time, and LOAD clock signal **Φ_{L}(280)** and its value **400** at a later time. FIG. 2 also shows the MEMS-device value **Q (290)** and its value **350** at a particular time before loading a new value into the MEMS device **20,** and FIG. 2 shows its complement **/Q (300)** and the value **410** of **/Q** at another time after loading the new value into the MEMS device **20.** Reference numeral **420** denotes a transition time interval during which the values of **Q** and **/Q** are indeterminate.

N-channel FET devices **120** are enabled when the STORE signal is asserted high. Devices **120** allow storage of the value of DATA and its complement /DATA when either the **A** or **B** capacitor select signal is asserted high. Storing a pixel value is done by asserting the STORE signal **220** at a high value and by also selecting **330** either the **A** or **B** storage capacitors with gates **80** or **90** (line **240** in FIG. 2). The bit line is driven differentially with DATA **200** and complementary /DATA **210** values, and the corresponding data value is stored into one of selected capacitors (**A** or **B**) on either side. Devices **120** also allow reading of stored charge on a selected one of the two capacitor storage cells after the stored charge is loaded into the sense amplifier. Reading is then done by enabling device **125** and either device **130** or **135**, and then enabling device **120** after the sense amplifier has amplified the storage-node charge signal. N-channel FET devices **125** are enabled when LOAD signal **230** (terminals **110** in FIG. 1) is asserted high.

N-channel FET device **130** is enabled when signal A is asserted high. Device **130** allows signals on DATA and /DATA to be stored on the respective capacitors when device **120** is also enabled at the same time. Device **130** also allows the storage capacitor value to be amplified and refreshed when devices **125** and **130** are enabled.

N-channel FET device **135** is enabled when signal B is asserted high. Device **135** allows signals on DATA and /DATA to be stored on the respective capacitors when device **120** is also enabled at the same time. Device **135** also allows storage capacitor value to be amplified and refreshed by the sense amplifier when devices **125** and **135** are enabled.

Loading the stored memory elements in the MEMS latch is done by first deasserting the two sense-amplifier clock signals **270(Φ_{S})** and **280 (Φ_{L}),** asserting the LOAD signal **230** at a high value, and selecting one of two stored values: **A** or **B (330)**.

N-channel FET devices **125** allow charged signal in one of two storage capacitors to be amplified by the sense amplifier when either **A** or **B** signal is asserted high and LOAD signal **230** (terminals **110** in FIG. 1) is asserted high.

FET devices **125** also allow reading of stored charge on one of two capacitor storage cells. Reading is done by enabling device **125** and either device **130** or **135** to select the **A** or **B** capacitor, and by then also enabling device **120** after the sense amplifier has amplified the storage node charge signal.

Once the cross-couple sense-amplifier has had sufficient time to differentiate the signal, the clock signal **50 (Φ_{S})** for the N-channel devices **160** is asserted at a high value to resolve the differential input signal. At a later time, both P-channel devices **140** are turned on, which pulls the high input side to VDD. To reduce power dissipation, the P-channel devices **140** are turned off once the required voltage is attained. The LOAD signal remains asserted (**370** in FIG. 2) until after the P-channel devices **140** are turned on. This allows the sense amplifier to refresh the selected **A** or **B** memory capacitor.

The same sense amplifier is also used to drive the data on the bit lines for read operations. Reading the stored pixel value requires the selection of one of two pixel values to be loaded into the sense amplifier and latched. Once the value is latched, the STORE line **220** is asserted high (**320** in FIG. 2) to allow the data to be driven on the bit lines. The end of the bit line has another sense amplifier (not shown) to sense the data and to provide sufficient gain to latch the read data quickly.

Thus, in the embodiment of FIGS. 1 and 2, the first dynamic memory element includes a first storage capacitor **A**, the second dynamic memory element includes a second storage capacitor **B**, and data is stored selectively in a selected storage capacitor **A** or **B** in accordance with a capacitor selection signal. The sense amplifier refreshes data stored in the selected capacitor in accordance with the capacitor selection signal. Similarly, data is loaded to the MEMS device selectively from a selected one of the storage capacitors **A** or **B** in accordance with the capacitor selection signal. Thus, the sense amplifier is adapted to read data stored in a selected one of the storage capacitors **A** or **B** in accordance with a read signal. As described above, the read signal is sent by enabling device **125** and either device **130** or **135** to select the **A** or **B** capacitor, and by then also enabling device **120** after the sense amplifier has amplified the storage node charge signal.

### FABRICATION

A display using the present invention and having a desired number of pixels arranged in an array may be made by providing a substrate and forming an array of MEMS devices on the substrate, at least one MEMS device corresponding to each pixel. Each MEMS device of the array is configured to be actuated by an electrical signal on at least one actuation electrode. The fabrication also includes forming on the substrate a dynamic memory cell for each pixel, each dynamic memory cell including first and second dynamic memory elements, each including at least one capacitor, both of the first and second memory elements being electrically coupled to the actuation electrode of the MEMS device corresponding to a single pixel. Each dynamic memory cell that is formed also includes a sense amplifier configured to amplify the data signal and to latch data in response to a data signal and a clock signal.

Forming the MEMS devices is accomplished using conventional MEMS processes well known to those skilled in the art, selecting those unit processes that are compatible with semiconductor processing of the dynamic memory elements. An example of such MEMS processes is the fabrication on the substrate of an array of digital micro-mirror devices, one or more digital micro-mirror devices corresponding to each pixel. The dynamic memory elements are formed by conventional semiconductor fabrication processes, such as conventional CMOS processes. Again, unit processes are chosen to be compatible with MEMS processing.

### INDUSTRIAL APPLICABILITY

Dynamic self-refreshing memory cells made in accordance with the present invention may be used for a variety of MEMS arrays, including arrays of digital micromirror display devices. Having more than one memory element per pixel reduces data bandwidth required for the MEMS devices, and the dynamic approach requires fewer transistors and thus smaller area than an equivalent two-memory conventional static approach. A local sense amplifier for each pixel allows refreshing of the selected pixel value and also allows driving the bit lines in read operations.

In accordance with a useful aspect of the invention, a method is provided for using a dynamic memory cell in a display of the type having at least one MEMS device corresponding to each pixel: a dynamic memory cell is provided for each pixel, each dynamic memory cell including first and second dynamic memory elements, each of the first and second dynamic memory elements including at least one capacitor. Both of the first and second memory elements are electrically coupled to the MEMS device corresponding to a single pixel. A differential data signal, a clock signal, and a capacitor selection signal are provided to each dynamic memory cell. In response to the differential data signal, the capacitor selection signal, and a first phase of the clock signal, data is stored in at least one capacitor of a selected one of the dynamic memory elements. Data is stored in at least one capacitor, refreshed, and amplified. In response to the capacitor selection signal and a second phase of the clock signal, selected data is loaded to the MEMS device corresponding to each pixel to display information in accordance with the differential data signal. If desired, this method can also include reading the data stored. This method can reduce the bandwidth required for a memory cell having one memory element per pixel by about half if just two memory elements are used per pixel. If a number N of memory elements per pixel larger than two is used, the bandwidth requirement can be further reduced.

Although the foregoing has been a description and illustration of specific embodiments of the invention, various modifications and changes thereto can be made by persons skilled in the art without departing from the scope of the invention as defined by the following claims. For example, various MEMS devices, including both display devices and other (non-display) MEMS devices may be used with memory cells made in accordance with the invention, either individually or arranged in arrays, and other MOS or bipolar transistors or other active devices may be used in place of the CMOS devices used in the illustrated embodiments.

## Claims

1. A memory cell (10) for a display of the type having at least one MEMS device (20) corresponding to each pixel, the memory cell (10) storing data in response to a data signal (60, 70) and a clock signal (40, 50), the memory cell (10) comprising:
at least two independent dynamic memory elements (130, 135) per pixel, including first and second dynamic memory elements (A, B), each of the first and second dynamic memory elements (A, B) including at least one capacitor, both of the first and second memory elements (A, B) being electrically coupled to the MEMS device (20) of a single pixel;
**characterized in that** the memory cell further comprises:
a sense amplifier (140,150,160) configured to amplify the data signal (60, 70) and to latch data in response to the data signal (60, 70) and the clock signal (40, 50), and wherein the sense amplifier (140,150,160) is configured to refresh data stored in a selected capacitor of the dynamic memory elements (A, B) of each pixel during loading data stored in the selected capacitor into the MEMS device (20) or during reading out data stored in the selected capacitor and to output the read data to a data line, whereby the memory cell (10) is a self-refreshing memory cell.

2. The memory cell of claim 1, **characterized in that** the at least two dynamic memory elements (A, B) comprise N dynamic memory elements per pixel, where N is an integer equal to or greater than two.

3. A memory for a display, **characterized in that** the memory comprising a plurality of memory cells, at least one memory cell (10) as recited in claim 1 for each pixel of the display.

4. A display device comprising the memory cell (10) of claim 1.

5. An integrated circuit comprising the memory cell (10) of claim 1.

6. A substrate carrying microelectronics comprising the memory cell (10) of claim 1.

7. An electronic device comprising the memory cell (10) of claim 1.

8. The memory cell of claim 1, **characterized in that** the at least one MEMS device (20) comprises a micro-mirror device.

9. The memory cell of claim 1, **characterized in that** the sense amplifier (140, 150, 160) amplifies the data signal to a predetermined level suitable for actuating the at least one MEMS device (20).

10. The memory cell of claim 9, **characterized in that** the predetermined level is suitable for actuating a micro-mirror device.

11. The memory cell of claim 1, **characterized in that** the first dynamic memory element (A) includes a first storage capacitor, the second dynamic memory element (B) includes a second storage capacitor, and the data is stored selectively in the selected one of the first and second storage capacitors in accordance with a capacitor selection signal (240).

12. The memory cell of claim 11, **characterized in that** the sense amplifier (140, 150, 160) is further configured to refresh data stored in the selected one of the first and second storage capacitors in accordance with the capacitor selection signal (240).

13. A method of making a display having a plurality of pixels, the method comprising the steps of:
providing a substrate;
forming an array of MEMS devices (20) on the substrate, at least one MEMS device (20) corresponding to each pixel, each MEMS device (20) of the array being configured to be actuated by an electrical signal on at least one actuation electrode;
**characterized in that** the method further comprises:
forming on the substrate a dynamic memory cell (10) for each pixel, each dynamic memory cell (10) including in dependent first and second dynamic memory elements (130,135), each of the first and second dynamic memory elements including at least one capacitor, both of the first and second memory elements being electrically coupled to actuation electrode of the at least one MEMS device (20) corresponding to a single pixel, and each dynamic memory cell (10) including a sensing amplifier (140,150,160) configured to amplify the data signal (60,70) and to latch data in response to a data signal (60,70) and a clock signal (40,50) , and wherein the sense amplifier (140, 150, 160) is configured to refresh data stored in a selected capacitor of the dynamic memory elements (A, B) of each pixel during loading data stored in the selected capacitor into the MEMS device (20) or during reading out data stored in the selected capacitor and to output the read data to a data line, whereby the memory cell (10) is a self-refreshing memory cell.

14. A display made in accordance with the method of claim 13.

## Patentansprüche

1. Eine Speicherzelle (10) für eine Anzeige des Typs mit zumindest einem MEMS-Bauelement (20), das jedem Pixel entspricht, wobei die Speicherzelle (10) ansprechend auf ein Datensignal (60, 70) und ein Taktsignal (40, 50) Daten speichert, wobei die Speicherzelle (10) folgende Merkmale aufweist:
zumindest zwei unabhängige dynamische Speicherelemente (130, 135) pro Pixel, die erste und zweite dynamische Speicherelemente (A, B) umfassen, wobei jedes der ersten und zweiten dynamischen Speicherelemente (A, B) zumindest einen Kondensator umfasst, wobei sowohl die ersten als auch die zweiten Speicherelemente (A, B) elektrisch gekoppelt sind mit dem MEMS-Bauelement (20) eines einzigen Pixels;
**dadurch gekennzeichnet, dass** die Speicherzelle ferner folgende Merkmale aufweist:
einen Leseverstärker (140, 150, 160), der konfiguriert ist, um das Datensignal (60, 70) zu verstärken und Daten ansprechend auf das Datensignal (60, 70) und das Taktsignal (40, 50) zwischenzuspeichern, und wobei der Leseverstärker (140, 150, 160) konfiguriert ist, um Daten aufzufrischen, die in einem ausgewählten Kondensator der dynamischen Speicherelemente (A, B) jedes Pixels gespeichert sind, während des Ladens von Daten, die in dem ausgewählten Kondensator gespeichert sind, in das MEMS-Bauelement (20), oder während des Auslesens von Daten, die in dem ausgewählten Kondensator gespeichert sind, und um die gelesenen Daten zu einer Datenleitung auszugeben, wodurch die Speicherzelle (10) eine selbstauffrischende Speicherzelle ist.

2. Die Speicherzelle gemäß Anspruch 1, **dadurch gekennzeichnet, dass** die zumindest zwei dynamischen Speicherelemente (A, B) N dynamische Speicherelemente pro Pixel aufweisen, wobei N eine Ganzzahl gleich oder größer 2 ist.

3. Ein Speicher für eine Anzeige, **dadurch gekennzeichnet, dass** der Speicher eine Mehrzahl von Speicherzellen aufweist, zumindest eine Speicherzelle (10) gemäß Anspruch 1 für jedes Pixel der Anzeige.

4. Eine Anzeigevorrichtung, die die Speicherzelle (10) gemäß Anspruch 1 aufweist.

5. Eine integrierte Schaltung, die die Speicherzelle (10) gemäß Anspruch 1 aufweist.

6. Ein Substrat, das Mikroelektronik trägt, die die Speicherzelle (10) gemäß Anspruch 1 aufweist.

7. Ein elektronisches Gerät, das die Speicherzelle (10) gemäß Anspruch 1 aufweist.

8. Die Speicherzelle gemäß Anspruch 1, **dadurch gekennzeichnet, dass** das zumindest eine MEMS-Bauelement (20) ein Mikrospiegelbauelement aufweist.

9. Die Speicherzelle gemäß Anspruch 1, **dadurch gekennzeichnet, dass** der Leseverstärker (140, 150, 160) das Datensignal auf einen vorbestimmten Pegel verstärkt, der zum Betätigen des zumindest einen MEMS-Bauelements (20) geeignet ist.

10. Die Speicherzelle gemäß Anspruch 9, **dadurch gekennzeichnet, dass** der vorbestimmte Pegel zum Betätigen eines Mikrospiegelbauelements geeignet ist.

11. Die Speicherzelle gemäß Anspruch 1, **dadurch gekennzeichnet, dass** das erste dynamische Speicherelement (A) einen ersten Speicherkondensator umfasst, das zweite dynamische Speicherelement (B) einen zweiten Speicherkondensator umfasst, und die Daten gemäß einem Kondensatorauswahlsignal (240) selektiv in dem ausgewählten der ersten oder zweiten Speicherkondensatoren gespeichert werden.

12. Die Speicherzelle gemäß Anspruch 11, **dadurch gekennzeichnet, dass** der Leseverstärker (140, 150, 160) ferner konfiguriert ist, um Daten aufzufrischen, die gemäß dem Kondensatorauswahlsignal (240) in dem ausgewählten der ersten oder zweiten Speicherkondensatoren gespeichert sind.

13. Ein Verfahren zum Herstellen einer Anzeige mit einer Mehrzahl von Pixeln, wobei das Verfahren folgende Schritte aufweist:
Bereitstellen eines Substrats;
Bilden eines Arrays von MEMS-Bauelementen (20) auf dem Substrat, wobei zumindest ein MEMS-Bauelement (20) jedem Pixel entspricht, wobei jedes MEMS-Bauelement (20) des Arrays konfiguriert ist, um durch ein elektrisches Signal auf zumindest einer Betätigungselektrode betätigt zu werden;
**dadurch gekennzeichnet, dass** das Verfahren ferner folgende Schritte aufweist:
Bilden, auf dem Substrat, einer dynamischen Speicherzelle (10) für jedes Pixel, wobei jede dynamische Speicherzelle (10) unabhängige erste und zweite dynamische Speicherelemente (130, 135) umfasst, wobei jedes der ersten und zweiten dynamischen Speicherelement zumindest einen Kondensator umfasst, wobei sowohl die ersten als auch die zweiten Speicherelemente elektrisch gekoppelt sind mit einer Betätigungselektrode des zumindest einen MEMS-Bauelements (20), das einem einzigen Pixel entspricht, und jede dynamische Speicherzelle (10) einen Leseverstärker (140, 150, 160) umfasst, der konfiguriert ist, um das Datensignal (60, 70) zu verstärken und ansprechend auf ein Datensignal (60, 70) und ein Taktsignal (40, 50) Daten zwischenzuspeichern, und wobei der Leseverstärker (140, 150, 160) konfiguriert ist, um Daten aufzufrischen, die in einem ausgewählten Kondensator der dynamischen Speicherelemente (A, B) jedes Pixels gespeichert sind, während des Ladens von Daten, die in dem ausgewählten Kondensator gespeichert sind, in das MEMS-Bauelement (20), oder während des Auslesens von Daten, die in dem ausgewählten Kondensator gespeichert sind, und um die gelesenen Daten zu einer Datenleitung auszugeben, wodurch die Speicherzelle (10) eine selbstauffrischende Speicherzelle ist.

14. Eine Anzeige, die gemäß dem Verfahren von Anspruch 13 hergestellt ist.

## Revendications

1. Cellule de mémoire (10) pour un affichage du type présentant au moins un dispositif MEMS (20) correspondant à chaque pixel, la cellule de mémoire (10) stockant des données en réponse à un signal de données (60, 70) et un signal d'horloge (40, 50), la cellule de mémoire (10) comprenant:
au moins deux éléments de mémoire dynamique indépendants (130, 135) par pixel, comportant un premier et un deuxième élément de mémoire dynamique (A, B), chacun des premier et
deuxième éléments de mémoire dynamique (A, B) comportant au moins un condensateur, tant le premier que le deuxième élément de mémoire (A, B) étant couplés électriquement au dispositif MEMS (20) d'un seul pixel;
**caractérisée par le fait que** la cellule de mémoire comprend par ailleurs:
un amplificateur de lecture (140, 150, 160) configuré pour amplifier le signal de données (60, 70) et pour verrouiller les données en réponse au signal de données (60, 70) et au signal d'horloge (40, 50), et dans laquelle l'amplificateur de lecture (140, 150, 160) est configuré pour régénérer les données stockées dans un condensateur sélectionné des éléments de mémoire dynamique (A, B) de chaque pixel pendant le chargement des données stockées dans le condensateur sélectionné dans le dispositif MEMS (20) ou pendant la lecture des données stockées dans un condensateur sélectionné et pour sortir les données lues vers une ligne de données, où la cellule de mémoire (10) est une cellule de mémoire à auto-régénération.

2. Cellule de mémoire selon la revendication 1, **caractérisée par le fait que** les au moins deux éléments de mémoire dynamique (A, B) comprennent N éléments de mémoire dynamique par pixel, où N est un nombre entier égal ou supérieur à deux.

3. Mémoire pour un affichage, **caractérisée par le fait que** la mémoire comprend une pluralité de cellules de mémoire, au moins une cellule de mémoire (10) selon la revendication 1 pour chaque pixel de l'affichage.

4. Dispositif d'affichage comprenant la cellule de mémoire (10) selon la revendication 1.

5. Circuit intégré comprenant la cellule de mémoire (10) selon la revendication 1.

6. Substrat portant une micro-électronique comprenant la cellule de mémoire (10) selon la revendication 1.

7. Dispositif électronique comprenant la cellule de mémoire (10) selon la revendication 1.

8. Cellule de mémoire selon la revendication 1, **caractérisée par le fait que** l'au moins un dispositif MEMS (20) comprend un dispositif micro-miroir.

9. Cellule de mémoire selon la revendication 1, **caractérisée par le fait que** l'amplificateur de lecture (140, 150, 160) amplifie le signal de données à un niveau prédéterminé convenant pour actionner l'au moins un dispositif MEMS (20).

10. Cellule de mémoire selon la revendication 9, **caractérisée par le fait que** le niveau prédéterminé convient pour actionner un dispositif micro-miroir.

11. Cellule de mémoire selon la revendication 1, **caractérisée par le fait que** le premier élément de mémoire dynamique (A) comporte un premier condensateur de stockage, le deuxième élément de mémoire dynamique (B) comporte un deuxième condensateur de stockage, et les données sont stockées sélectivement dans l'un sélectionné parmi les premier et deuxième condensateurs de stockage selon un signal de sélection de condensateur (240).

12. Cellule de mémoire selon la revendication 11, **caractérisée par le fait que** l'amplificateur de lecture (140, 150, 160) est par ailleurs configuré pour régénérer les données stockées dans l'un sélectionné parmi les premier et deuxième condensateurs de stockage selon un signal de sélection de condensateur (240).

13. Procédé pour réaliser un affichage présentant une pluralité de pixels, le procédé comprenant les étapes consistant à:
préparer un substrat;
former un réseau de dispositifs MEMS (20) sur le substrat, au moins un dispositif MEMS (20) correspondant à chaque pixel, chaque dispositif MEMS (20) du réseau étant configuré pour être actionné par un signal électrique sur au moins une électrode d'actionnement;
**caractérisé par le fait que** le procédé comprend par ailleurs le fait de:
former sur le substrat une cellule de mémoire dynamique (10) pour chaque pixel, chaque cellule de mémoire dynamique (10) comportant un premier et un deuxième élément de mémoire dynamique indépendants (130, 135), chacun des premier et deuxième éléments de mémoire dynamique comportant au moins un condensateur, tant le premier que le deuxième élément de mémoire étant couplés électriquement à l'électrode d'actionnement de l'au moins un dispositif MEMS (20) correspondant à un seul pixel, et chaque cellule de mémoire dynamique (10) comportant un amplificateur de lecture (140, 150, 160) configuré pour amplifier le signal de données (60, 70) et pour verrouiller les données en réponse à un signal de données (60, 70) et un signal d'horloge (40, 50), et dans lequel l'amplificateur de lecture (140, 150, 160) est configuré pour régénérer les données stockées dans un condensateur sélectionné des éléments de mémoire dynamique (A, B) de chaque pixel pendant le chargement des données stockées dans le condensateur sélectionné dans le dispositif MEMS (20) ou pendant la lecture des données stockées dans un condensateur sélectionné et pour sortir les données lues vers une ligne de données, où la cellule de mémoire (10) est une cellule de mémoire à auto-régénération.

14. Affichage réalisé selon le procédé de la revendication 13.
